# EUROPÄISCHE PATENTSCHRIFT

(11) **EP 1 155 170 B1**
(45) Veröffentlichungstag und Bekanntmachung des Hinweises auf die Patenterteilung: **11.12.2002**
(21) Anmeldenummer: 00908957.4
(22) Anmeldetag: 01.02.2000
(51) Int. Cl.: C30B 7/00, C30B 29/38, C23C 18/12, C30B 9/00

(54) **VERFAHREN ZUR HERSTELLUNG VON NITRID-EINKRISTALLEN**
METHOD FOR PRODUCING NITRIDE MONOCRYSTALS
PROCEDE DE PRODUCTION DE MONOCRISTAUX DE NITRURE

(30) Priorität: 03.02.1999 DE 19904378
(43) Veröffentlichungstag der Anmeldung: 21.11.2001
(73) Patentinhaber: Osram Opto Semiconductors GmbH & Co. OHG, 93049 Regensburg (DE)
(72) Erfinder: HÄRLE, Volker, D-93164 Waldetzenberg (DE)
(74) Vertreter: Epping Hermann & Fischer
(86) Internationale Anmeldenummer: DE0000267
(87) Internationale Veröffentlichungsnummer: WO00046431

(56) Entgegenhaltungen:
- EP-A- 0 295 467
- EP-A- 0 429 272
- WO-A-86/06361
- PATENT ABSTRACTS OF JAPAN vol. 011, no. 176 (C-426), 5. Juni 1987 (1987-06-05) & JP 62 001874 A (MITSUBISHI ELECTRIC CORP), 7. Januar 1987 (1987-01-07)
- PATENT ABSTRACTS OF JAPAN vol. 014, no. 390 (C-0751), 23. August 1990 (1990-08-23) & JP 02 145773 A (TOSHIBA LIGHTING & TECHNOL CORP), 5. Juni 1990 (1990-06-05)
- NUTT ET AL: "synthesis and characterization of ((trimethysilyl)amino)- and (methyl(trimethylsilyl)amino)gallium dichloride" INORGANIC CHEMISTRY, Bd. 24, Nr. 1, 2. Januar 1985 (1985-01-02), Seiten 159-164, XP000920832 usa in der Anmeldung erwähnt
- RIEDEL ET AL.: "Bis(dichlor-N-trimethylsilyl)cycloaminoal an kristall struktur and thermischer Abbau zu Aluminiumnitrid" Z.ANORG.AALG.CHEM, Bd. 603, 1991, Seiten 119-127, XP000907633 leipzig in der Anmeldung erwähnt

## Beschreibung

Die Erfindung bezieht sich auf ein Verfahren zur Herstellung von Nitrid-Einkristallen gemäß Patentanspruch 1.

Die Herstellung hoch effizienter Bauelementstrukturen wie Halbleiterlaser und lichtemittierende Dioden erfordert Substratkristalle mit höchster Kristallperfektion. Insbesondere Bauelemente basierend auf nitridischen Halbleitern wie z.B. Ga(In,Al)N, mit denen seit neuestem der ultraviolette bis blaugrüne Spektralbereich des sichtbaren Spektrums erschlossen werden kann, können diese Anforderung nur bedingt liefern, da die notwendigen Halbleiterschichtfolgen auf sogenannten Fremdsubstraten (Saphir; SiC; Si; GaAs, etc.) abgeschieden werden. Perfekte Kristalle erfordern jedoch den Einsatz von "Homosubstraten", also Substrate des gleichen oder artverwandten Materials, um die für die Bauelemente geforderten niedrigen Versetzungsdichten zu realisieren.

Nitridische Kristalle weisen sehr hohe Bindungsenergien auf. Zur Herstellung entsprechender Substratkristalle sind deshalb extrem hohe Drücke sowie Temperaturen um 1000°C und mehr notwendig. Die existenten Verfahren basieren entweder auf Methoden, die unter hohem Druck die Bildung der Kristalle aus der Schmelze ermöglichen, oder auf einem Sublimationsverfahren, bei welchem das Kristallwachstum im wesentlichen aus der Gasphase erfolgt. Auch Quasikristalle führen zur Reduktion der Versetzungsdichten, beinhalten aber - bedingt durch die physikalisch vorliegende Gitterfehlanpassung - Verspannungen, die nur über die störenden Versetzungen abgebaut werden können. Solche Quasikristalle werden durch Abscheidung dicker Nitrid-Filme auf Fremdsubstraten (wie Saphir, SiC; Si; GaAs etc.) erzielt. Als Verfahren finden z.B. die metallorganische Gasphasenepitaxie sowie die Hydrid-Gasphasenepitaxie Anwendung.

Die hier beschriebenen Verfahren sind einerseits sehr aufwendig und teuer, andererseits liefern sie nicht die angestrebte Kristallperfektion.

Der vorliegenden Erfindung liegt somit die Aufgabe zugrunde, ein Verfahren zur Herstellung von Nitriden, insbesondere von (Ga, Al)Ni anzugeben, welches einerseits möglichst kostengünstig ist und andererseits eine möglichst perfekte einkristalline Struktur ermöglicht.

Das erfindungsgemäße Verfahren zur Lösung dieser Aufgabe basiert auf der thermischen Um- und Zersetzung (Pyrolyse) einer organischen Substanz, die die atomaren Bestandteile des zu bildenden Nitrid-Einkristalls enthält. Diese organische Substanz ist in einer Lösung oder in einer Schmelze enthalten, die bei einer ersten Temperatur gehalten wird. In der Lösung oder der Schmelze befindet sich ein aus dem aufzuwachsenden oder einem artverwandten Nitridmaterial bestehender Substratkeim. Diesem Substratkeim wird Wärmeenergie zugeführt, so daß sich zumindest an seiner mit der Schmelze in Kontakt stehenden Oberfläche eine zweite Temperatur einstellt, die größer als die erste Temperatur ist. Dadurch kommt es an der erwärmten Oberfläche zur Bildung und Ablagerung von Nitrid-Molekülen und somit zum Wachstum des Nitrideinkristalls.

In Veröffentlichungen von R. Riedel et al. (Z.anorg.allg. Chem. 603 (1991), 119-127) und W. Rodger Nutt et al. (Inorg. Chem. 1985, 24, 159-164) wurde beispielsweise gezeigt, daß AlN- und GaN-"Kriställchen" aus der thermischen Umsetzung verschiedener organischer Substanzen (Bis(dichlo-N-trimethylsilyl)cyclo-aminoalan; (Trimethylsilyl)amino- und Methyl(trimethylsilyl)amino-Galliumdichlorid) hergestellt werden können. Ziel des hier beschriebenen Verfahrens ist die gezielte thermische Zersetzung an einer Kristalloberfläche. Hierzu wird das gewünschte oder ein artverwandtes Material als "Kristallkeim" zur Verfügung gestellt. Die gezielte Erwärmung eben dieser Oberfläche führt zur Zersetzung der organischen Verbindungen, die sich entweder in einer Schmelze oder einer Lösung befinden. Es entstehen Nitrid-Moleküle, die alle erforderlichen Atome für den Kristallbau beinhalten. Die Erwärmung der Oberfläche des Keimes führt dazu, daß die entstehenden Moleküle sich auch nur dort ablagern können, was zum Kristallwachstum führt. Ein derartiges Verfahren ist überaus kostengünstig und erfordert nur einen geringen apparativen Aufwand.

In bevorzugter Weise ist die die organische Substanz enthaltende Lösung oder Schmelze in einem Gefäß enthalten und der Kristallkeim ist entlang eines Abschnitts der Gefäßinnenwand angeordnet, wobei die Wärmeenergie durch diesen Abschnitt der Gefäßinnenwand dem Substratkeim zugeführt wird.

Die Wärmeenergie kann auf unterschiedliche Arten zugeführt werden. Beispielsweise kann der Substratkeim mit der von einer Strahlungsquelle, insbesondere einer Infrarot-Strahlungsquelle, emittierten Strahlung, beaufschlagt werden. Es kann aber die Wärmeenergie auch induktiv zugeführt werden. Eine weitere Möglichkeit besteht darin, die Wärmeenergie über eine Widerstandsheizung zuzuführen. Diese kann Widerstandsdrähte enthalten, die in dem Abschnitt der Gefäßwand verlaufen und mit einem elektrischen Strom beaufschlagbar sind.

Die Erfindung wird im folgenden anhand von Ausführungsbeispielen in den Zeichnungen näher beschrieben. In den Zeichnungen zeigen:
Fig.1 eine schematische Anordnung zur Durchführung des erfindungsgemäßen Verfahrens;
Fig.2 A bis C Ausführungsformen bezüglich der Zuführung der Wärmeenergie zu dem Substratkeim.

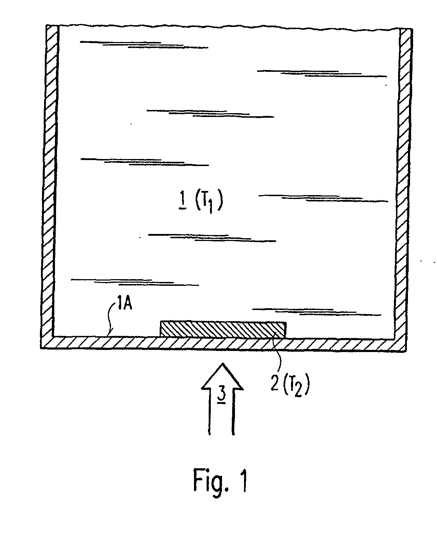

In der Fig.1 ist eine schematische Anordnung zur Durchführung des erfindungsgemäßen Verfahrens gezeigt.

Diese Anordnung enthält ein Gefäß 1 zur Aufnahme einer flüssigen Lösung oder Schmelze, in der eine organische Verbindung enthalten ist, die die atomaren Bestandteile des zu bildenden Nitrid-Einkristalls enthält. Die Lösung oder Schmelze wird auf einer ersten Temperatur T₁ gehalten, indem das Gefäß 1 beispielsweise in einem Ofen aufbewahrt wird und die Temperatur des Ofens auf die Temperatur T₁ eingestellt wird. Am Boden des Gefäßes 1 ist ein Substratkeim 2 angeordnet, der aus dem aufzuwachsenden oder einem artverwandten Nitrid besteht. Dieser Substratkeim 2 wird mittels einer Energiezufuhr, die durch den Pfeil 3 symbolisiert ist, erwärmt, so daß mindestens seine mit der Schmelze in Kontakt stehende Oberfläche eine Temperatur T₂ einnimmt, die größer als T₁ ist. Dies ermöglicht eine thermische Zersetzung der organischen Substanz und die Bildung und Anlagerung von Nitrid-Molekülen an den Substratkeim 2.

Wenn beispielsweise Galliumnitrid (GaN) aufgewachsen werden soll, kann, wie in der eingangs zitierten Publikation von Nutt et al. beschrieben, als organische Substanz (Trimethylsilyl)amino-Galliumdichlorid oder Methyl(trimethylsilyl)amino-Galliumdichlorid verwendet werden.

Wenn dagegen Aluminiumnitrid (AlN) aufgewachsen werden soll, kann, wie in der eingangs zitierten Publikation von Riedel et al. beschrieben, als organische Substanz Bis(dichlor-N-trimethylsilyl)cycloaminoalan verwendet werden.

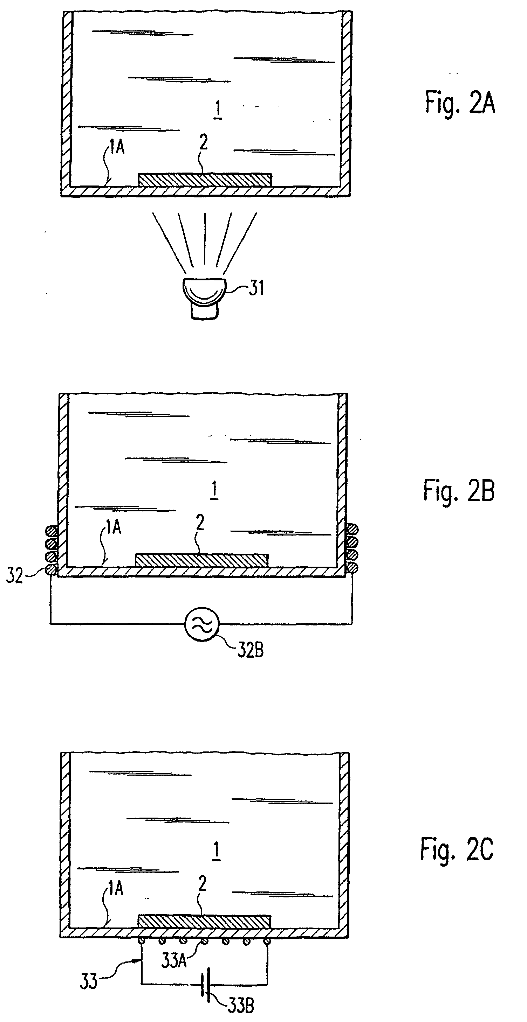

In den Figuren 2A bis 2C sind drei verschiedene Ausführungsarten für die Energiezufuhr dargestellt. Der Pfeil 3 der Fig.1 ist somit in diesen Figuren durch entsprechende denkbare Strukturen ersetzt.

Gemäß Fig.2A ist zu Zwecken der Strahlungsheizung unterhalb des Gefäßes 1 eine Lichtquelle 31, vorzugsweise eine Infrarot-Lichtquelle, angeordnet, deren emittierte Strahlung auf den Abschnitt der Gefäßwand gerichtet ist, an dem sich der Substratkeim 2 befindet. Zusätzlich kann eine spezielle Optik aus Linsen und/oder Spiegeln angeordnet werden, um die emittierte Strahlung zu parallelisieren, zu bündeln, und/oder auf bestimmte Stellen der Gefäßwand zu richten. Theoretisch denkbar ist auch, daß sich der Substratkeim 2 an irgendeiner Stelle in der Schmelze befindet und die Strahlung einer externen Lichtquelle mittels einer geeigneten Optik auf ihn fokussiert wird.

In der Anordnung der Fig.2B wird die Heizenergie durch induktive Kopplung zugeführt. Zu diesem Zweck ist der untere Abschnitt des Gefäßes 1 mit einer Spulenwicklung 32 umgeben, die mit einem Wechselstrom aus einer Wechselspannungsquelle 32B beaufschlagt wird. Auch hier gibt es eine räumliche Freiheit insoweit, als die Spulenwicklung 32 und somit der Substratkeim 2 an jeder Längsposition des Gefäßes 1 angeordnet werden können.

Bei der Anordnung der Fig.2C wird die Wärmeenergie durch eine Widerstandsheizung 33 zugeführt. Die Widerstandsheizung 33 weist einen Widerstandsdraht 33A auf, der im Kontakt mit der Gefäßwand steht und durch eine Gleichspannungsquelle 33B mit einem Gleichstrom beaufschlagt werden kann. Dadurch entsteht Joulesche Wärme, die durch die Gefäßwand in den Substratkeim 2 eindringen kann. Der Widerstandsdraht 33A bildet dabei vorzugsweise eine schlangen- oder spiralförmige Bahn und bedeckt somit eine bestimmte Fläche, um diese möglichst homogen mit Wärmeenergie zu beaufschlagen. Er kann fest in die Gefäßwand mit nach außen geführten Anschlußdrähten eingebettet sein. Denkbar ist jedoch auch, daß er bei Bedarf außen auf die Gefäßwand in dafür vorgesehene Vertiefungen eingesetzt wird.

Mit diesem Verfahren kann die Wärme dem Substratkeim 2 sehr gezielt zugeführt werden, der Substratkeim 2 muß jedoch an der Gefäßwand positioniert werden.

Eine vierte nicht dargestellte Möglichkeit der Energiezufuhr besteht in der Zufuhr von Mikrowellenenergie. Zu diesem Zweck kann unterhalb des Gefäßes 1 eine Mikrowellenquelle wie beispielsweise ein Magnetron angeordnet sein. Die von diesem emittierte Mikrowellenstrahlung kann mit oder ohne Verwendung eines Mikrowellenleiters dem Abschnitt der Gefäßwand zugeführt werden, an dem der Substratkeim 2 positioniert ist.

Die Zufuhr der Energie mittels elektromagnetischer Strahlung oder auf induktivem Wege hat gegenüber der Widerstandsheizung den Vorteil, daß der Substratkeim 2 sich prinzipiell irgendwo in der Schmelze befinden kann. Bei der Widerstandsheizung muß der Substratkeim 2 dagegen mit einer Gefäßwand in Kontakt stehen.

Zusätzlich zu der beschriebenen und erfindungsgemäßen Temperatursteuerung des Wachstumsprozesses können weitere Maßnahmen zur Homogenisierung des Wachstumsprozesses ergriffen werden. Beispielsweise kann die Schmelze während des Aufwachsens permanent durch einen mechanischen Rührer umgerührt werden. Es kann auch der Substratkeim 2 während des Aufwachsens um seine Zylinderachse gedreht werden und/oder mit langsamer Geschwindigkeit durch die Lösung gezogen werden. Ferner kann zur Beeinflussung des Kristallwachstums ein statisches oder sich ebenfalls drehendes elektrisches Feld oder Magnetfeld angelegt werden. Schließlich kann eine laminare Strömung in der Lösung erzeugt werden, indem man beispielsweise in einem auf den Substratkeim gerichteten Rohr die Lösung auf den Substratkeim strömen läßt. Alle genannten Maßnahmen können beliebig miteinander kombiniert werden, um optimale Wachstumsbedingungen zu schaffen.

## Patentansprüche

1. Verfahren zur Herstellung eines für die Halbleiterfertigung geeigneten Substrats aus einem Nitrid-Einkristall, **gekennzeichnet durch** die Verfahrensschritte
- Bereitstellen einer eine organische Verbindung enthaltenden Lösung oder Schmelze bei einer ersten Temperatur T₁, wobei
- die organische Verbindung die atomaren Bestandteile des zu bildenden Nitrid-Einkristalls enthält, und wobei
- sich in der Schmelze ein Substratkeim des aufzuwachsenden oder eines artverwandten Nitrids befindet,
- Zufuhr von Wärmeenergie zu dem Substratkeim, so daß zumindest seine mit der Schmelze in Berührung stehende Oberfläche eine Temperatur T₂ > T₁ einnimmt.

2. Verfahren nach Anspruch 1,
**dadurch gekennzeichnet, daß**
- die Schmelze sich in einem Gefäß befindet, und
- der Substratkeim entlang mindestens eines Abschnitts der Gefäßwand angeordnet ist, und
- die Wärmeenergie durch diesen Abschnitt der Gefäßwand dem Substratkeim zugeführt wird.

3. Verfahren nach Anspruch 1 oder 2,
**dadurch gekennzeichnet, daß**
- die Wärmeenergie durch die Strahlung einer Strahlungsquelle, insbesondere einer Infrarot-Strahlungsquelle zugeführt wird.

4. Verfahren nach Anspruch 1 oder 2,
**dadurch gekennzeichnet, daß**
- die Wärmeenergie induktiv eingekoppelt wird.

5. Verfahren nach Anspruch 1 und 2,
**dadurch gekennzeichnet, daß**
- die Wärmeenergie durch eine Widerstandsheizung zugeführt wird,
- die mit einem elektrischen Strom beaufschlagbare Widerstandsdrähte enthält, die mit der Gefäßwand in Kontakt stehen.

6. Verfahren nach Anspruch 5,
**dadurch gekennzeichnet, daß**
- die Widerstandsdrähte in die Gefäßwand eingebettet sind.

7. Verfahren nach Anspruch 1 oder 2,
**dadurch gekennzeichnet, daß**
- die Widerstandsdrähte in die Gefäßwand eingebettet sind.

8. Verfahren nach Anspruch 1 oder 2,
**dadurch gekennzeichnet, daß**
- die Wärmeenergie durch Mikrowellenstrahlung zugeführt wird.

9. Verfahren nach Anspruch 1,
**dadurch gekennzeichnet, daß**
- das Nitrid AlN ist, und
- die organische Verbindung Bis(dichlor-N-trimethylsilyl)cycloaminoalan ist.

10. Verfahren nach Anspruch 1,
**dadurch gekennzeichnet, daß**
- das Nitrid GaN ist, und
- die organische Verbindung (Trimethylsilyl)amino-Galliumdichlorid oder Methyl(trimethylsilyl)amino-Galliumdichlrod ist.

## Claims

1. Method for producing, from a nitride single crystal, a substrate which is suitable for semiconductor fabrication, **characterized by** the method steps of
- preparing a solution or melt containing an organic compound at a first temperature T₁, in which step
- the organic compound contains the atomic components of the nitride single crystal to be formed, and in which step
- a substrate seed of the nitride to be grown, or of a related nitride, is located in the melt,
- supplying heat energy to the substrate seed, so that at least its surface which is in contact with the melt assumes a temperature T₂ > T₁.

2. Method according to Claim 1, **characterized in that**
- the melt is located in a vessel, and
- the substrate seed is arranged along at least one section of the vessel wall, and
- the heat energy is supplied to the substrate seed through this section of the vessel wall.

3. Method according to Claim 1 or 2, **characterized in that**
- the heat energy is supplied by using radiation from a radiation source, in particular an infrared radiation source.

4. Method according to Claim 1 or 2, **characterized in that**
- the heat energy is coupled in inductively.

5. Method according to Claim 1 or 2, **characterized in that**
- the heat energy is supplied by using a resistive heater,
- which contains resistive wires to which an electric current can be applied, and which are in contact with the vessel wall.

6. Method according to Claim 5, **characterized in that**
- the resistive wires are embedded in the vessel wall.

7. Method according to Claim 1 or 2, **characterized in that**
- the resistive wires are embedded in the vessel wall.

8. Method according to Claim 1 or 2, **characterized in that**
- the heat energy is supplied by using microwave radiation.

9. Method according to Claim 1, **characterized in that**
- the nitride is AlN, and
- the organic compound is bis(dichloro-N-trimethylsilyl)cycloaminoalane.

10. Method according to Claim 1, **characterized in that**
- the nitride is GaN, and
- the organic compound is (trimethylsilyl)amino-gallium dichloride or methyl(trimethylsilyl)amino-gallium dichloride.

## Revendications

1. Procédé de fabrication d'un substrat en monocristal de nitrure approprié à la fabrication d'un semiconducteur, **caractérisé par** les stades de procédé qui consistent :
- à disposer d'une solution ou d'une masse fondue contenant un composé organique à une première température T₁ alors que,
- le composé organique contient les constituants atomiques du monocristal de nitrure à former et alors que,
- il se trouve, dans la masse fondue, un germe de substrat du nitrure à faire croître ou d'un nitrure de type apparenté,
- à apporter de l'énergie calorifique au germe de substrat de façon à ce qu'au moins sa surface en contact avec la masse fondue prenne une température T₂ > T₁.

2. Procédé suivant la revendication 1,
**caractérisé en ce que**,
la masse fondue se trouve dans un récipient et
- le germe de substrat est disposé le long d'au moins une partie de la paroi du récipient, et
- l'énergie calorifique est apportée par cette partie de la paroi du récipient au germe de substrat.

3. Procédé suivant la revendication 1 ou 2,
**caractérisé en ce que**,
- l'énergie calorifique est apportée par le rayonnement d'une source de rayonnement, notamment d'une source de rayonnement infrarouge.

4. Procédé suivant la revendication 1 ou 2, **caractérisé en ce que** l'énergie calorifique est injectée par voie inductive.

5. Procédé suivant la revendication 1 et 2, **caractérisé en ce que**,
- l'énergie calorifique est apportée par un chauffage par résistance,
- qui a des fils de résistance qui peuvent être alimentés par un courant électrique et qui sont en contact avec la paroi du récipient.

6. Procédé suivant la revendication 5, **caractérisé en ce que**,
- les fils de résistance sont incorporés à la paroi du récipient.

7. Procédé suivant la revendication 1 ou 2, **caractérisé en ce que**,
- les fils de résistance sont incorporés à la paroi du récipient.

8. Procédé suivant la revendication 1 ou 2, **caractérisé en ce que**,
- l'énergie calorifique est apportée par rayonnement micro-onde.

9. Procédé suivant la revendication 1, **caractérisé en ce que**,
- le nitrure est AIN et,
- le composé organique est le bis(dichloro-N-triméthylsilyl)cyclo-aminoalane.

10. Procédé suivant la revendication 1, **caractérisé en ce que**,
- le nitrure est GaN, et
- le composé organique est le dichlorure de (triméthylsilyl)amino-gallium ou le dichlorure de méthyl(triméthylsilyl)aminogallium.
